# FASCICULE DE BREVET EUROPEEN

(11) **EP 0 746 188 B1**
(45) Date de publication et mention de la délivrance du brevet: **18.07.2001**
(21) Numéro de dépôt: 96401143.1
(22) Date de dépôt: 28.05.1996
(51) Int. Cl.: H05K 3/34, H01L 23/498

(54) **Utilisation d'un micromodule comme boîtier de montage en surface**
Verwendung eines Mikromoduls als oberflächenmontiertes Gehäuse
Use of micromodule as surface mount package

(30) Priorité: 29.05.1995 FR 9506328
(43) Date de publication de la demande: 04.12.1996
(73) Titulaire: STMicroelectronics S.A., 94250 Gentilly (FR)
(72) Inventeur: Steffen, Francis, 94230 Cachan (FR)
(74) Mandataire: Schmit, Christian Norbert Marie

(56) Documents cités:
- EP-A- 0 391 790
- EP-A- 0 408 904
- EP-A- 0 498 446
- EP-A- 0 623 956
- EP-A- 0 624 053
- DE-A- 3 536 431
- FR-A- 2 487 580
- GB-A- 2 115 607
- IBM TECHNICAL DISCLOSURE BULLETIN, vol. 36, no. 10, Octobre 1993, NEW YORK US, pages 481-483, XP000412454 "Ball limiting annulus structure for C4 bump formation"

## Description

La présente invention concerne un micromodule de circuit intégré étant utilisé comme boîtier de montage en surface sur un substrat d'interconnexions.

Le montage en surface groupe un ensemble d'opérations pour déposer des composants miniatures sur la surface d'un circuit imprimé ou d'un substrat sérigraphié de circuit hybride.

Les composants sont placés par des machines de placement automatique sur le substrat, puis soudés. Ils ne sont pas munis de fils de sortie et ne nécessitent pas de trous dans le circuit pour leur fixation. Leur conditionnement se fait en bandes alvéolées ou en tubes. Ils sont aspirés pour être reportés ensuite sur le substrat.

On appelle micromodule, l'ensemble miniature formé principalement d'une ou plusieurs puces de circuit intégré et d'un connecteur formé de fines zones de contact sensiblement planes, et destiné à être inséré dans un support d'information de faible épaisseur, du type carte à puce ou clef à mémoire, en sorte que le connecteur affleure en surface du support d'information, la puce étant noyée dans le support. Le connecteur comporte six à huit zones de contact réparties en deux rangées qui permettent 5 à 8 accès normalisés à la puce : masse électrique GND, alimentation logique VCC, tension de programmation VPP (pas toujours utilisée), remise à zéro RST, horloge CLK et entrée/sortie en série de données I/O, deux autres zones étant disponibles pour des applications spécifiques ou futures (connecteur à 8 contacts). Des normes internationales définissent les différentes caractéristiques des micromodules (ISO 7810 à 7816). Une de ces caractéristiques est leur faible épaisseur. En effet, un micromodule a typiquement une épaisseur inférieure à 0,6 millimètre.

Différents procédés industriels de fabrication des micromodules ont été développés.

Un premier procédé connu consiste principalement à reporter une puce sur une bande métallique qui supporte les zones de contact découpées mécaniquement. La puce est connectée par des fils soudés aux différentes zones de contact. La puce et les fils sont ensuite enrobés d'une goutte de résine de protection. On obtient une bande de micromodules en série. Un découpage permet d'obtenir les micromodules individuels qui vont ensuite être encartés.

Pour résoudre les problèmes d'adhérence de la résine sur la grille métallisée et de débordement de la résine sur les zones de contact du connecteur, on utilise de préférence du diélectrique moulé ou transféré à chaud sur la grille, de manière à réaliser un support métallisé simple face, sur lequel la puce est reportée du côté diélectrique et connectée par des fils passant par des perforations du diélectrique et soudés sur les zones de contact.

Un autre procédé connu de réalisation d'un support métallisé simple face pour micromodules utilise une bande diélectrique perforée, sur une face de laquelle on lamine du métal. Le métal est ensuite gravé pour former les zones de contact du connecteur.

D'autres procédés utilisent enfin un film support métallisé double face, une face pour la connexion à la puce, l'autre face formant le connecteur.

Dans un perfectionnement, une enceinte métallique ou diélectrique est prévue, qui entoure la puce et ses connexions. Cette enceinte est remplie de résine de protection (thermodurcissable de type silicone ou thermoplastique de type polyuréthanne). On obtient un micromodule de forme et dimensions parfaitement reproductibles et contrôlées. L'enceinte de protection remplie de résine protège efficacement la puce et ses connexions des agressions chimiques et contraintes mécaniques. Un tel micromodule et procédé correspondant est par exemple décrit dans la demande de brevet européen publiée sous le numéro 0 391 790, déposée le 3 avril 1990 sous le numéro 90 400909.

Ces micromodules ont été développés principalement pour des applications dites sécurisées : carte prépayée jetable ou rechargeable, contrôle d'accès, carte d'abonnement, carte bancaire, carte de télévision à péage, carte monoservice ou multiservices (...). Pour ces applications des micromodules, des puces de circuit intégré ont été spécialement développées, qui intègrent différents systèmes de protection et respectent une connectique normalisée.

Dans les puces de mémoire simples, des systèmes de protection sont prévus en logique câblé. Des fusibles permettent d'empêcher l'accès en écriture de certaines zones de la mémoire. Un code porteur de l'utilisateur de la carte peut être prévu, pour autoriser l'accès en lecture/écriture de zones mémoires et pour bloquer la puce en cas de présentation de code porteur erroné (cartes volées). Un code émetteur de l'organisme qui délivre la carte à l'utilisateur peut être contenu dans la puce, pour la bloquer si ce code est erroné (fausses cartes).

Dans les puces à microprocesseur, des systèmes de protection plus sophistiqués peuvent être utilisés avec notamment la mise en oeuvre d'algorithmes cryptographiques pour sécuriser les transferts de données, l'utilisation systématique des codes porteur et émetteur, la possibilité de réhabiliter une carte (puce débloquée) (...).

Un système d'exploitation logicielle existe qui permet en outre la gestion dynamique de la mémoire ou le chargement de programmes spécifiques au moment de la personnalisation de la carte.

Toutes ces puces sécurisées comportent en outre des capteurs de sécurité qui contrôlent les conditions opérationnelles d'utilisation de la carte : fréquence du signal d'horloge CLK pas trop basse, tension d'alimentation logique Vcc pas trop élevée, présence de la couche de passivation finale de la puce, (...).

Les capteurs délivrent chacun une information binaire, utilisée directement pour déclencher une sécurité matérielle (blocage) ou mémorisée pour être exploitée par un programme de gestion des anomalies.

Le blocage de la puce est obtenu par exemple en forçant à zéro le niveau du signal de remise à zéro (RST) ou en bloquant l'accès à des informations stratégiques.

La technologie normalisée des micromodules a donc conduit à développer des puces de circuit intégré avec 5 à 8 sorties, hautement sécurisées tant sur le plan matériel que logiciel, qui ont permis l'essor des cartes à micromodules que l'on connaît.

Le développement de nombres d'applications électroniques pour l'informatique ou la télématique passe par la sécurisation des accès et des transferts de données. Dans ce but, des lecteurs à puces ont été intégrés à des micro-ordinateurs, des lecteurs de clefs à mémoire personnalisées ont été prévus dans des décodeurs de chaînes cryptées.

Dans l'invention, on a cherché à résoudre le problème de sécurité pour des matériels électroniques ou informatiques autres que des cartes à puce, sur les cartes à circuit imprimé ou substrat sérigraphié.

Ce qui aurait pu venir à l'esprit, était d'utiliser une puce sécurisée développée pour les micromodules, comme un composant électronique classique, en la plaçant dans un boîtier de semi-conducteurs normalisé, par exemple un boîtier DIL ou SO.

Cependant, on a vu que ces puces utilisent de 5 à 8 sorties. De plus, les puces des micromodules les plus complexes occupent une grande surface. Ces puces nécessitent donc des boîtiers DIL ou SO larges à au moins 8 ou 16 sorties.

Or, la complexité croissante des applications électroniques nécessite une miniaturisation de plus en plus poussée, notamment dans des domaines qui s'adressent à des installations embarquées ou chez des particuliers : il est nécessaire de proposer des matériels à la fois performants et peu encombrants. Dans ces conditions, l'ajout d'un ou plusieurs boîtiers à 8 ou 16 sorties sur un circuit imprimé peut s'avérer difficile pour certaines de ces applications.

Pour résoudre ces différents problèmes, la demanderesse a eu l'idée d'utiliser directement les micromodules comme boîtiers de montage en surface sur les substrats d'interconnexions. De cette manière, on utilise une technologie très au point en ce qui concerne la sécurité, et qui permet en outre une haute intégration.

Telle que caractérisée, l'invention concerne donc l'utilisation d'un micromodule comme boîtier de montage en surface sur un substrat d'interconnexions.

Le connecteur normalisé du micromodule est formé de zones de contact affleurantes en surface, qui servent de plages de contact a au moins une puce de circuit intégré contenue dans le micromodule.

Selon l'invention ces zones de contact sont aussi utilisées comme plages de montage en surface du micromodule sur un substrat d'interconnexion.

Pour mettre en oeuvre cette invention, la Demanderesse s'est heurtée à un autre problème, du fait de la nature du connecteur du micromodule.

Le connecteur d'un micromodule est en effet formé de fines zones de contact sensiblement planes en adhérence sur une surface diélectrique déformable. Une petite différence de niveau des zones de contact est usuelle et une légère déformation de la surface diélectrique possible. En pratique, la surface de connectique du micromodule n'est pas parfaitement plane. Ce qui n'est pas un problème dans le contexte des cartes à micromodules, pour lesquels les lecteurs comprennent des connecteurs parfaitement adaptés, devient un problème important quand il s'agit d'assurer un contact et une conduction fiables entre les zones de contact du micromodule et les plots de contact en surface d'un circuit imprimé.

Par ailleurs, selon les normes ISO applicables, les zones de contact ont une surface importante, de l'ordre de 4 à 5 mm² et deux zones d'une même rangée sont distantes d'environ 0,2 à 0,84 mm. Si on veut souder un micromodule sur un substrat d'interconnexions, même en choisissant un espacement optimum entre les zones de contact du connecteur du micromodule, dans le cadre de ce qui est autorisé par les normes ISO applicables, le risque de court-circuit entre les zones de contact est très important. Pour une connexion électrique avec des plots de contact en surface d'un substrat d'interconnexions, la zone de soudure utile pour chaque contact devra donc être plus petite que la surface de la zone de contact, de manière à éviter les courts-circuits dûs aux tolérances en rotation et en x et y des machines de placement automatique. On choisit donc des plots de contact petits sur le substrat. Mais la soudure risque aussi de s'étaler naturellement sur toute la surface des zones de contact du connecteur du micromodule. On risque encore des courts-circuits.

Pour résoudre ces problèmes de connexion, on prévoit dans un mode de réalisation de l'invention de réaliser une barrière à l'expansion de soudure entre au moins chaque zone de contact utile du micromodule et un plot de contact correspondant du substrat d'interconnexions.

Cette barrière peut être mécanique ou physico-chimique. Elle est de préférence conductrice.

Dans un autre mode de réalisation de l'invention, on prévoit qu'une extrémité des zones de contact du micromodule est libre, pour permettre son cambrage, de manière à former, sur le pourtour du micromodule, des broches adaptées au montage en surface sur un substrat d'interconnexions.

Un autre problème est apparu dans la légèreté et la déformabilité de la surface de connectique du micromodule. En effet, un espace minimum est nécessaire et imposé entre un boîtier et la surface du circuit imprimé, notamment pour permettre le nettoyage du circuit imprimé et empêcher la formation d'agrégats, et pour permettre une bonne connexion électrique. Or, si on utilise par exemple une opération de soudure à l'air chaud, une pression doit être appliquée sur le micromodule pour le maintenir au contact du substrat d'interconnexions pendant l'apport d'air chaud par dessous le micromodule. Le micromodule risque alors de se déformer ou de s'enfoncer trop, ce qui risque de faire déborder la soudure au-delà des barrières prévues.

Dans le premier mode de réalisation de l'invention, on prévoit alors une butée mécanique entre le micromodule et le substrat d'interconnexions pour imposer l'épaisseur d'interface de soudure. Avantageusement, cette butée mécanique permet de coller le micromodule au substrat avant l'opération de soudure.

Dans l'autre mode de réalisation de l'invention, les broches formées dans des prolongements des zones de contact du connecteur du micromodule, servent à la fois de connectique et de butée mécanique.

Pour fiabiliser le routage et placement des micromodules par des machines automatiques, on utilise de préférence des micromodules comportant l'enceinte de protection, vue plus haut, qui permet une bonne reproductibilité des dimensions du micromodule et confère au micromodule une bonne protection aux agressions chimiques et contraintes mécaniques.

D'autres caractéristiques et avantages de l'invention seront mieux compris à la lecture de la description suivante, faite en regard des dessins annexés donnés à titre d'exemples non limitatifs, dans lesquels :
- les figures 1 à 3 sont des vues de profil de micromodules montés en surface sur un substrat d'interconnexions selon l'invention,
- la figure 4 représente une vue en coupe transversale médiane d'un exemple de bande de micromodules qui comportent des barrières à l'expansion de soudure et une butée mécanique selon un mode de réalisation de l'invention,
- les figures 5 et 6 sont des vues en perspective de dessus (côté puce) et de dessous (côté connectique) d'un micromodule correspondant,
- la figure 7 est une vue en coupe de la connexion d'une zone de contact d'un micromodule sur un plot de contact d'un substrat d'interconnexions selon le premier mode de réalisation,
- la figure 8 représente une variante de la figure 7, avec des boules de soudure à l'état solide.
- les figures 9 et 10 sont des vues en perspective de dessus (côté puce) et de dessous (côté connectique) d'un micromodule selon un autre mode de réalisation de l'invention.

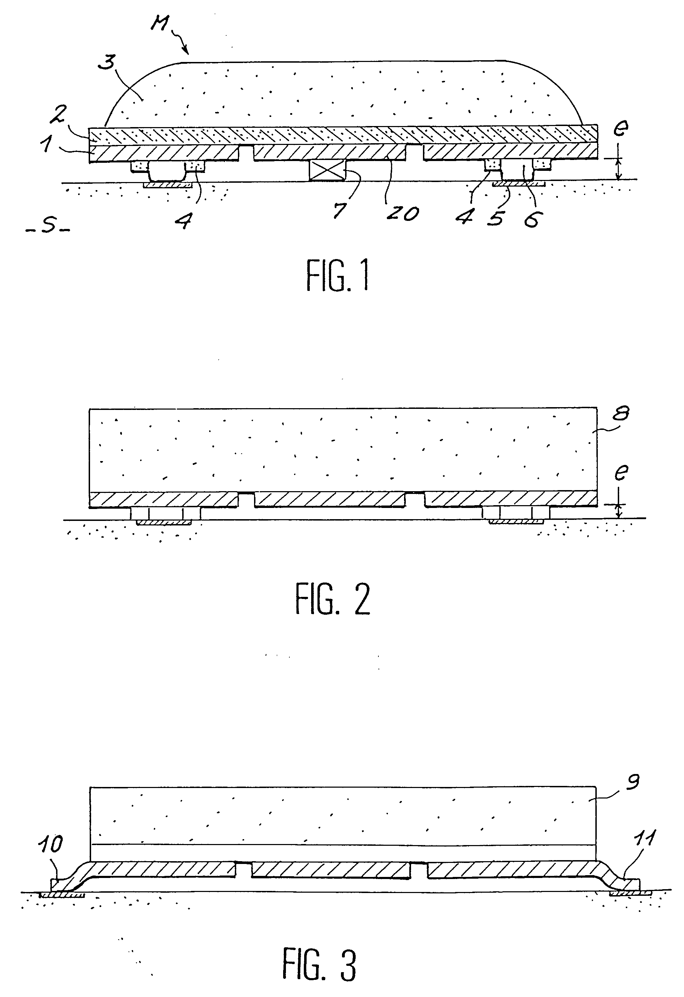

Les figures 1 à 3 représentent différentes formes de micromodules correspondant aux procédés de fabrication déjà décrits et montés en surface d'un substrat d'interconnexions. Le substrat d'interconnexions peut être par exemple un circuit imprimé, un substrat sérigraphié ou gravé.

La figure 1 montre ainsi des zones de contact 1 d'un micromodule M, en surface d'un écran diélectrique 2 2 dans une perforation ou un évidement duquel a été placée la puce (non représentée). La puce est connectée aux zones de contact par des fils qui passent par des perforations de l'écran et qui sont soudés sur les zones de contact. Une goutte de résine de protection 3 enrobe la puce et ses fils de connexion.

Selon un mode réalisation de l'invention, des barrières 4 à l'expansion de soudure sont prévues entre la surface de connectique formée par les zones de contact 1 et la surface correspondante d'un substrat sérigraphié 5.

Ce sont des barrières mécaniques ou physico-chimiques. Leur épaisseur est inférieure ou égale à l'épaisseur e de l'interface de soudure S.

Dans l'exemple de la figure 1, leur épaisseur est inférieure à e.

De préférence, ces barrières sont réalisées sur les zones de contact du micromodule. Elle sont par exemple réalisées par tampographie ou sérigraphie quand elles sont mécaniques, ou par spray au travers d'un écran quand elles sont physico-chimiques. Quand elles sont mécaniques, on peut aussi prévoir de les rapporter par collage sur le micromodule.

Elles sont de préférence conductrices, ce qui permet une meilleure dilatation thermique de l'ensemble de la connexion. Mais il n'y a pas contre-indication à ce qu'elles soient isolantes.

Dans l'exemple représenté à la figure 1, le micromodule est en outre muni de boules 6 de soudure à l'état solide, déposées à l'intérieur des barrières 4. Les barrières permettent plus particulièrement d'empêcher l'étalement des boules sur les plages de contact, et donc de contrôler l'épaisseur de l'interface de soudure. Dans ce cas, si les barrières sont conductrices, ces barrières servent avantageusement de renfort de soudure après la refusion.

Enfin, une butée mécanique 7 7 a été prévue, qui consiste dans l'exemple de la figure 1 1 en un élément central, placé entre la zone de contact centrale Z0 du micromodule et une zone correspondante du substrat.

La figure 2 représente un micromodule monté en surface selon le même mode de réalisation mais avec des barrières 4 de l'épaisseur de l'interface de soudure S et sans butée mécanique.

Le micromodule est ici pourvu d'une enceinte de protection 8, qui entoure la puce et ses connexions et qui est remplie de résine de protection. Dans l'exemple représenté, cette enceinte est en matière diélectrique, formée avec l'écran par moulage.

La figure 3 représente un autre micromodule monté en surface d'un substrat sérigraphié 5 selon un autre mode de réalisation de l'invention. Le micromodule a ici une enceinte de protection 9 en métal. Des zones de contact sont pourvues d'une extrémité libre 10 et 11, sur le pourtour du micromodule. Ces extrémités sont cambrées en sorte qu'elles forment des broches de boîtier de montage en surface. Ces broches servent avantageusement à la fois pour la connexion sur le substrat d'interconnexions et de butée mécanique.

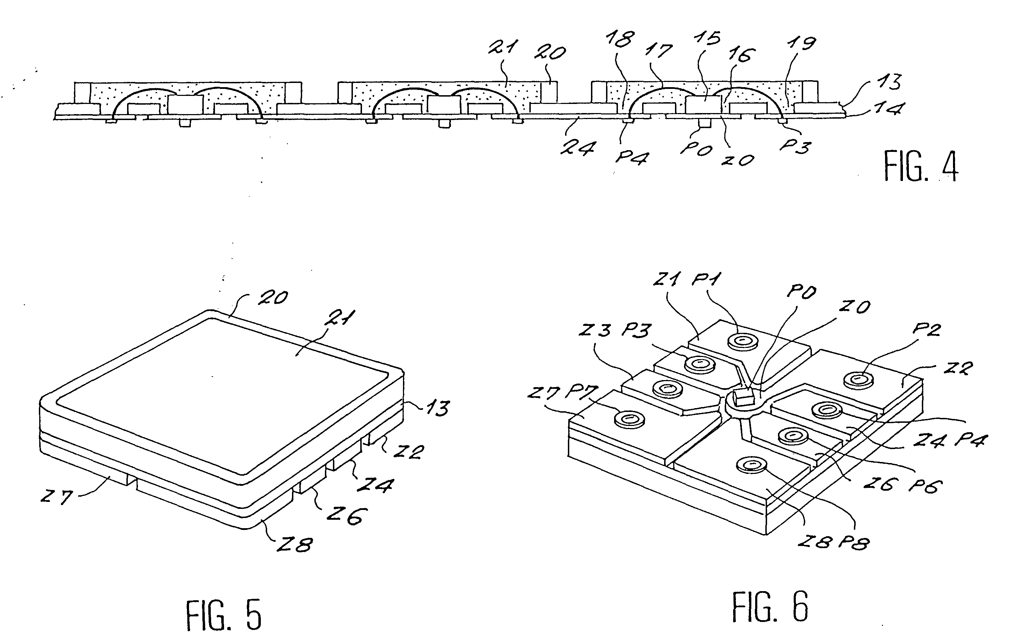

Les figures 4 à 6 représentent un micromodule du type à enceinte de protection en métal sur lequel des barrières et une butée mécanique ont été formées conformément au premier mode de réalisation de l'invention (figures 1 et 2).

La figure 4 représente ainsi une bande de micromodules en série, telle qu'elle peut être obtenue selon un procédé de moulage continu d'une bande diélectrique perforée 13 sur une grille de métal 14 qui porte les connecteurs prédécoupés. Pour chaque micromodule à réaliser, une puce 15 est placée dans une perforation 16 de l'écran sur une zone centrale ZO du connecteur et les fils de connexion 17 de la puce sont amenés sur des zones de contact Z3, Z4 du connecteur, via d'autres perforations 18, 19 de l'écran, et soudés (technique de report automatique sur bande, TAB).

Une enceinte de protection 20, ici en métal, est moulée sur l'écran diélectrique, qui entoure la puce 15 et ses connexions 17. Cette enceinte est remplie de résine de protection 21 (figure 5).

Selon un mode de réalisation de l'invention, des barrières à l'expansion de soudure sont en outre réalisées.

On rappelle que le connecteur du micromodule comprend 2 rangées de 3 à 4 zones de contact, Z1 à Z8 dans les figures 5 à 6, avec 1 zone de contact Z2 qui se prolonge dans l'exemple dans une partie centrale de la surface de connectique, sous la puce. Cette zone centrale Z0 n'est pas utilisée pour réaliser une connexion électrique externe du micromodule au circuit imprimé.

On réalise une barrière à l'expansion de soudure pour au moins chacune des zones de contact qui doivent être connectées électriquement à des plots de contact correspondants du substrat d'interconnexions. En pratique, pour simplifier le procédé, on peut réaliser ces barrières pour chacune des zones de contact du connecteur du micromodule. Dans l'exemple représenté à la figure 6, les 8 zones de contact Z1 à Z8 du connecteur du micromodule comportent chacune une barrière en forme d'enceinte P1 à P8.

Ces barrières sont par exemple mécaniques. Elles peuvent alors être réalisées en résine, par sérigraphie, sur la grille de métal 14. La résine utilisée sera de préférence un vernis synthétique tel celui utilisé pour réaliser la couche d'épargne soudure d'un circuit imprimé. C'est un vernis qui résiste à la température de soudure, qui empêche les court-circuits entre des conducteurs rapprochés et protège de l'oxydation des conducteurs en cuivre. Ce vernis est très résistant, de surface dure et adhère aussi bien sur le cuivre que sur le substrat du circuit imprimé (substrat époxy par exemple).

Elle peut aussi être en matériau conducteur (métal), ce qui est avantageux en terme de dilatation thermique pour la connexion.

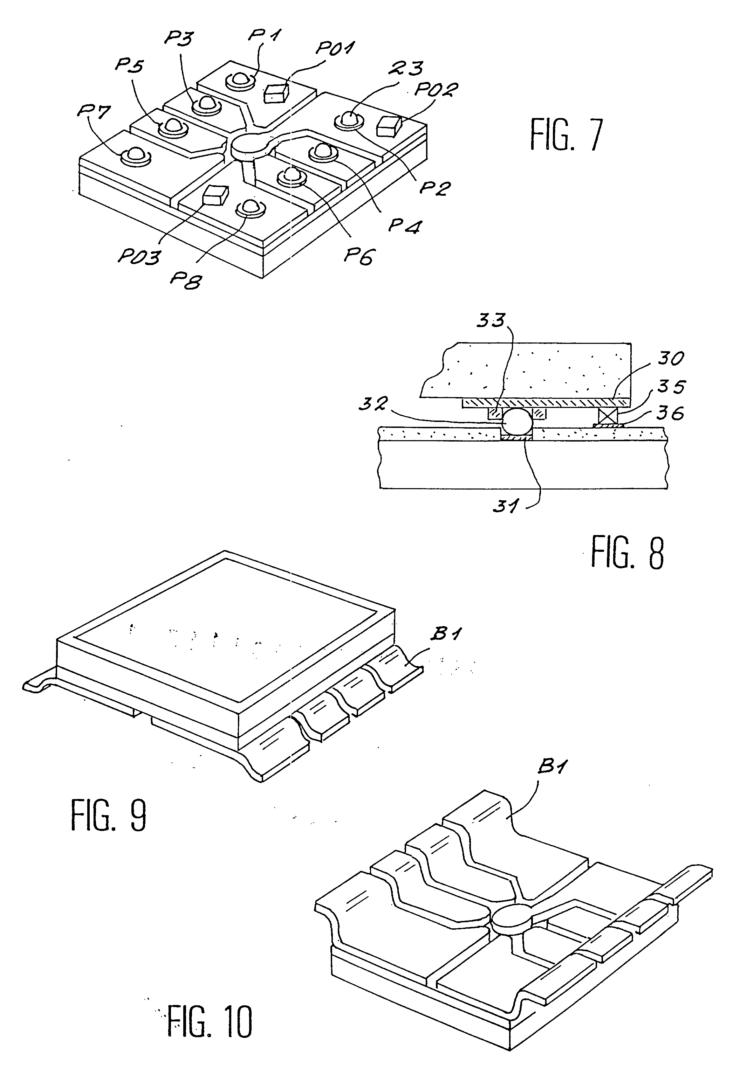

Dans l'exemple représenté sur les figures 4 à 6, chaque micromodule comprend aussi une butée mécanique. Sur ces figures, la butée mécanique comprend un élément central noté P0 et positionné sur la zone de contact centrale Z0, qui dans l'exemple est contigüe à la zone de contact Z2. La butée mécanique peut aussi comprendre au moins trois éléments P01, P02, P03 définissant un plan, comme représenté sur la figure 7.

Les éléments de butée mécanique ont une épaisseur de l'ordre de l'épaisseur e déterminée de l'interface de soudure.

Ils peuvent être réalisés en matériau isolant ou conducteur. Par exemple, ils sont réalisés en résine, par tampographie, sérigraphie ou report. Enfin, on peut réaliser ces éléments de butée mécanique ou bien sur la surface de connectique du micromodule, ou bien sur la surface du substrat d'interconnexions.

Dans une variante représentée sur la figure 7, on prévoit dans la fabrication de la bande de micromodules, de déposer une bille ou une boule 23 de pâte à souder à l'état solide, par exemple une bille solide d'étain-plomb, dans chacune des enceintes intercalaires P1-P8, calibrée pour le volume de l'enceinte. Cette solution est particulièrement favorable au placement correct du micromodule sur le circuit imprimé (concentration de l'énergie dans la pointe de la bille en fusion, qui favorise l'autoalignement mécanique du micromodule sur le circuit imprimé).

La bande de micromodules obtenue selon ce premier mode de réalisation de l'invention peut donc revêtir différents aspects, selon que les boules de soudure ou les éléments de butée mécanique sont prévus. Elle peut être utilisée directement par une machine de placement automatique qui assure le découpage de chaque micromodule.

La bande de micromodules peut aussi être découpée et les micromodules individuels obtenus placés dans des bandes alvéolées ou dans des tubes, qui sont des magasins d'alimentation usuels des machines de placement automatique.

Les micromodules obtenus sont adaptés à la soudure par refusion sur des plots de contact du substrat d'interconnexions.

Pour la soudure à l'air chaud ou par phase vapeur, on dépose par sérigraphie ou transfert de la pâte à souder suffisamment poisseuse pour assurer en outre le maintien en place des micromodules. On peut aussi prévoir de l'adhésif au niveau de la butée mécanique, ce qui permet de maintenir en place le micromodule pendant l'opération de soudure.

La figure 8 8 représente une vue en coupe d'une connexion d'une zone de contact 30 d'un micromodule M selon l'invention sur un plot de contact 31 d'un substrat d'interconnexions, pour une soudure à l'air chaud.

Dans l'exemple, le plot de contact 31 étamé est délimité par une couche de vernis d'épargne soudure.

Une barrière 33 réalisée selon l'invention sur la zone de contact 30 contient une boule calibrée de soudure 32 (Etain-Plomb par exemple).

Une butée mécanique 35 selon l'invention est réalisée sur cette même zone de contact 30 et collée (36) sur le substrat.

Une pression P peut alors être appliquée sur le micromodule et l'apport d'air chaud fait refondre localement la boule 32 qui s'écrase sur le plot de contact 31, l'écrasement étant contrôlé par la butée mécanique 35 qui maintient l'épaisseur de l'interface de soudure.

On a vu qu'en pratique, les 8 zones de contact d'un connecteur du micromodule ne sont pas toujours utilisées. Notamment, pour les puces à microprocesseur, seulement 6 zones de contact sont utilisées pour l'interface électrique. Dans certains cas, des connecteurs de micromodule à 6 zones de contact peuvent alors être réalisés. La carte bancaire en est un exemple. Ou bien des connecteurs à 8 zones de contact sont utilisés avec 2 zones de contact non utiles, sans affectation électrique.

L'invention s'applique bien entendu à ces différentes variantes. Notamment, on peut prévoir de réaliser les butées mécaniques sur les zones de contact non utiles. On peut aussi connecter ces zones de contact non utiles sur des plots correspondants du substrat d'interconnexions, selon le procédé de l'invention.

En utilisant des barrières pour délimiter l'expansion de la soudure et donc délimiter la zone de connexion entre le micromodule et le substrat d'interconnexions, ou des broches, on élimine les risques de court-circuit liés aux tolérances de positionnement en X, Y et rotation des machines de placement automatique.

De préférence dans le mode de réalisation avec barrières, on prévoit que la zone de connexion pour une zone de contact du micromodule, délimitée par une enceinte intercalaire, n'excède pas 1 mm² environ. On peut ensuite choisir un espacement optimum entre les zones de contact du connecteur du micromodule, dans le cadre de ce qui est autorisé par les normes ISO, pour ne pas favoriser la formation de court-circuits.

Enfin, les barrières et butées peuvent être de forme quelconque. Dans les exemples représentés, les enceintes sont annulaires et les butées de forme cubique.

Un autre mode de réalisation de l'invention est représenté sur les figures 9 et 10, qui consiste à transformer les zones de contact du connecteur d'un micromodule en broches de montage en surface.

Ainsi, selon l'invention, on prévoit dans ce cas que les zones de contact sont pourvues d'extrémités libres, qui dépassent le pourtour du micromodule. On prévoit par exemple que la bande de micromodules vue à la figure 4, et qui comprend une bande d'écran diélectrique moulée sur la grille métallique qui forme les zones de contact, est exposée à une lumière pour pratiquer une ouverture dans l'écran diélectrique pour permettre de découper la bande dans ces ouvertures. On obtient des micromodules individuels avec des extrémités libres de métal sur leur pourtour, qui sont les languettes qui retenaient les zones de contact prédécoupées du connecteur à la grille 14 de la bande de fabrication. Une opération de cambrage permet alors de former des broches B1 de montage en surface des micromodules par soudure électrique. Les différentes formes de broches de montage en surface peuvent être réalisées selon ce procédé qui ne se limite pas à la forme donnée en exemple sur les figures 9 et 10. Les broches ainsi formées servent alors avantageusement à la fois de connexion et de butée mécanique.

Dans le cas de ces micromodules avec broches de montage en surface selon le deuxième mode de réalisation de l'invention et comme vu en relation avec les figures 9 à 10, on peut prévoir plusieurs broches par zones de contact. Il suffit qu'une zone de contact prédécoupée soit rattachée à la grille de métal support par plusieurs languettes. On effectue le découpage loin des zones de contact, de manière à garder ces languettes comme extrémités libres pour chaque zone de contact. Ces languettes peuvent ensuite être cambrées. L'opération de découpage et cambrage peut être réalisée par la machine de placement automatique comprenant les outils adaptés.

Les différents modes et variantes de réalisation décrits permettent un montage en surface fiable et industriel de micromodules. La déformabilité et la légèreté du micromodule sont judicieusement compensées par les butées mécaniques qui peuvent être obtenues par simple sérigraphie, ou par les broches. Ces adaptations peu coûteuses permettent aussi de limiter les risques de court-circuit liés à la forme des zones de contact du micromodule.

## Revendications

1. Micromodule (M) comprenant une ou plusieurs puces de circuit intégré et un connecteur assemblés selon la technologie des cartes à puce, caractérisé en ce qu'il est utilisé comme boîtier de montage en surface sur un substrat d'interconnexions (S).

2. Micromodule pour une utilisation comme boîtier de montage en surface selon la revendication 1, le micromodule comprenant un connecteur normalisé formé de zones de contact affleurantes en surface, caractérisé en ce que les zones de contact (Z1-Z8) du connecteur du micromodule s'étendent au-delà du pourtour du micromodule, pour former des languettes destinées à être cambrées pour réaliser des broches (B1) de montage en surface lesdites broches servant à la fois de connexion avec le substrat et de butée mécanique.

3. Micromodule selon la revendication 2, caractérisé en ce que les languettes sont constituées par des prolongements maintenant attachés les contacts sur une bande de fabrication.

4. Micromodule pour une utilisation comme boîtier de montage en surface selon la revendication 1, le micromodule comprenant un connecteur normalisé formé de zones de contact affleurantes en surface, caractérisé en ce qu'il comprend une barrière à l'expansion de soudure (4) délimitant une zone de connexion sur chaque contact utile du connecteur du micromodule.

5. Micromodule selon la revendication 4, caractérisé en ce que la barrière est en forme d'enceinte.

6. Micromodule selon la revendication 4, caractérisé en ce que la barrière est physico-chimique ou mécanique.

7. Micromodule selon l'une quelconque des revendications 4 4 à 5, caractérisé en ce que la barrière est thermiquement conductrice.

8. Micromodule selon l'une quelconque des revendications 4 à 7, caractérisé en ce qu'il comprend une boule calibrée de soudure (6) à l'état solide à l'intérieur de chacune des barrières (4).

9. Micromodule selon l'une quelconque des revendications 4 à 8, caractérisé en ce qu'il comprend en outre une butée mécanique (6) réalisée sur la surface du connecteur.

10. Micromodule selon la revendication 9, caractérisé en ce que la butée mécanique comprend un élément central (P0), sur une zone centrale (Z0) du connecteur du micromodule.

11. Micromodule selon la revendication 9, caractérisé en ce que la butée mécanique comprend au moins trois éléments (P01, P02, P03) répartis sur le connecteur de manière à former un plan.

12. Bande de micromodules en série selon l'une quelconque des revendications 2 à 11.

## Claims

1. Micromodule (M) comprising one or more integrated circuit chips and a connector, all assembled according to chip card technology, characterised in that it is used as a can for surface mounting on an interconnection substrate (S).

2. Micromodule for use as a surface-mounting can according to Claim 1, the micromodule comprising a standard connector formed by contact regions projecting on the surface, characterised in that the contact regions (Z1-Z8) of the micromodule extend beyond the periphery of the micromodule, in order to form tongues intended to be arched in order to produce pins (B1) for surface mounting, the said pins serving both for connection with the substrate and as a mechanical stop.

3. Micromodule according to Claim 2, characterised in that the tongues consist of extensions keeping attached the contacts on a manufacturing strip.

4. Micromodule for use as a surface-mounting can according to Claim 1, the micromodule comprising a standard connector formed by contact regions projecting on the surface, characterised in that it comprises a barrier to the expansion of solder (4) delimiting a connection region on each useful contact of the micromodule connector.

5. Micromodule according to Claim 4, characterised in that the barrier is in the form of an enclosure.

6. Micromodule according to Claim 4, characterised in that the barrier is physico-chemical or mechanical.

7. Micromodule according to any one of Claims 4 to 5, characterised in that the barrier is thermally conductive.

8. Micromodule according to any one of Claims 4 to 7, characterised in that it comprises a calibrated ball of solder (6) in the solid state inside each of the barriers (4).

9. Micromodule according to any one of Claims 4 to 8, characterised in that it also comprises a mechanical stop (6) produced on the surface of the connector.

10. Micromodule according to Claim 9, characterised in that the mechanical stop comprises a central element (P0), on a central region (Z0) of the micromodule connector.

11. Micromodule according to Claim 9, characterised in that the mechanical stop comprises at least three elements (P01, P02, P03) distributed on the connector so as to form a plane.

12. Band of micromodules in series according to any one of Claims 2 to 11.

## Patentansprüche

1. Mikromodul (M), der einen oder mehrere IC-Chips und einen Verbinder enthält, die gemäß der Technologie der Chipkarten zusammengesetzt sind, dadurch gekennzeichnet, daß er als Gehäuse zur Oberflächenmontage auf einem Verbindungssubstrat (S) verwendet wird.

2. Mikromodul zur Verwendung als Gehäuse zur Oberflächenmontage gemäß Anspruch 1, wobei der Mikromodul einen standardisierten Verbinder aufweist, der aus an der Oberfläche bündig anliegenden Kontaktzonen gebildet wird, dadurch gekennzeichnet, daß die Kontaktzonen (Z1-Z8) des Verbinders des Mikromoduls sich über den Umfang des Mikromoduls hinaus erstrecken, um Zungen zu bilden, die gekrümmt werden, um Stifte (B1) zur Oberflächenmontage zu bilden, wobei die Stifte sowohl zur Verbindung mit dem Substrat als auch als mechanischer Anschlag dienen.

3. Mikromodul nach Anspruch 2, dadurch gekennzeichnet, daß die Zungen aus Verlängerungen bestehen, die die Kontakte an einem Herstellungsband befestigt halten.

4. Mikromodul zur Verwendung als Gehäuse zur Oberflächenmontage gemäß Anspruch 1, wobei der Mikromodul einen standardisierten Verbinder aufweist, der aus an der Oberfläche bündig anliegenden Kontaktzonen gebildet wird, dadurch gekennzeichnet, daß er eine Sperre gegen die Ausdehnung von Lötmittel (4) aufweist, die eine Verbindungszone auf jedem nützlichen Kontakt des Verbinders des Mikromoduls begrenzt.

5. Mikromodul nach Anspruch 4, dadurch gekennzeichnet, daß die Sperre die Form eines Raums hat.

6. Mikromodul nach Anspruch 4, dadurch gekennzeichnet, daß die Sperre physikalisch-chemisch oder mechanisch ist.

7. Mikromodul nach einem der Ansprüche 4 bis 5, dadurch gekennzeichnet, daß die Sperre wärmeleitend ist.

8. Mikromodul nach einem der Ansprüche 4 bis 7, dadurch gekennzeichnet, daß er eine kalibrierte Lötmittelkugel (6) im festen Zustand innerhalb jeder der Sperren (4) aufweist.

9. Mikromodul nach einem der Ansprüche 4 bis 8, dadurch gekennzeichnet, daß er außerdem einen mechanischen Anschlag (6) aufweist, der an der Oberfläche des Verbinders ausgebildet ist.

10. Mikromodul nach Anspruch 9, dadurch gekennzeichnet, daß der mechanische Anschlag ein zentrales Element (P0) in einer zentralen Zone (Z0) des Verbinders des Mikromoduls aufweist.

11. Mikromodul nach Anspruch 9, dadurch gekennzeichnet, daß der mechanische Anschlag mindestens drei Elemente (P01, P02, P03) aufweist, die so auf dem Verbinder verteilt sind, daß sie eine Ebene bilden.

12. Band von Mikromodulen in Reihe nach einem der Ansprüche 2 bis 11.
